# EUROPÄISCHE PATENTANMELDUNG

(11) **EP 3 399 251 A1**
(43) Veröffentlichungstag der Anmeldung: **07.11.2018**
(21) Anmeldenummer: 18169477.9
(22) Anmeldetag: 26.04.2018
(51) Int. Cl.: F24F 13/30, H05K 7/20

(54) **KLIMAGERÄT FÜR DOPPELBODENSYSTEME**

(30) Priorität: 04.05.2017 DE 102017109552
(71) Anmelder: Weiss Doppelbodensysteme GmbH, 73527 Schwäbisch-Gmünd (DE)
(72) Erfinder: GOTTSCHLING, Bernt, 70197 Stuttgart (DE)
(74) Vertreter: Götz, Georg Alois

(57) **Zusammenfassung**

Klimagerät (7) für ein Doppelbodensystem, vorzugsweise geeignet zur Temperierung von geschlossenen Räumen, aufweisend wenigstens eine von einem Wärmeübertragerfluid durchströmte oder durchströmbare Wärmeübertragereinrichtung (9) zum Erwärmen oder Abkühlen von durch das Klimagerät (7) durchströmender Luft (20),
wobei die Wärmeübertragereinrichtung (9) wenigstens einen Wärmetauscher (32, 33) mit einer plattenförmigen Grundform aufweist, welcher Wärmetauscher (32, 33) mit wenigstens einer Rohrleitung (33) und vorzugsweise mit Lamellen (32) gebildet ist,
wobei die in das Klimagerät (7) einströmende bzw. von dem Klimagerät (7) angesaugte Luft (20) mit einer in das Klimagerät (7) integrierten Strömungseinrichtung, vorzugsweise wenigstens einem Ventilator (31), bereitgestellt ist und die Strömungseinrichtung zwischen einem Lüftungsgitter (14) und der Wärmeübertragereinrichtung (9) angeordnet ist,
**dadurch gekennzeichnet, dass**
der Wärmetauscher (32, 33) gegenüber der horizontalen Ebene (h) einen Neigungswinkel (α) größer als 0° zum Abfluss von Kondensat an der luftzugewandten Seite der Wärmeübertragerfläche aufweist.

## Beschreibung

Die Erfindung betrifft ein Klimagerät gemäß Oberbegriff des Anspruchs 1, vorzugsweise zur Kühlung von geschlossen Räumen mit geringem Platzangebot, beispielsweise Serverräumen. Ferner betrifft die Erfindung eine Bodenplatte für einen Doppelboden mit einem Klimagerät gemäß Oberbegriff des Anspruch 12. Auch wenn in der nachfolgenden Anmeldung Kühlvorgänge beschrieben werden, ist die Erfindung nicht nur zur Kühlung, sondern auch zur Erwärmung von Räumen geeignet.

Doppelbodensysteme können beispielsweise in Bürogebäuden oder auch Laborgebäuden zum Einsatz kommen. Dabei wird über dem ersten Boden ein aus Bodenplatten aufgebauter zweiter Boden eingezogen. Zwischen dem ersten und dem zweiten Boden wird dadurch ein Zwischenraum geschaffen, in dem Versorgungseinrichtungen, wie beispielsweise Strom- und Netzwerkkabel oder andere Rohrleitungen untergebracht werden können. Derartige Doppelbodensysteme werden insbesondere in Serverräumen verwendet, da dort aufgrund des geschaffenen Zwischenraums innerhalb der Doppelbodenebene die Vielzahl an Kabeln und Leitungen verlegt werden kann, ohne dass der Serverraum unbegehbar wird. Da heutzutage stets mit einer Erweiterung der Serverinfrastruktur und damit mit einem höheren Platzbedarf der Server im Raum zu rechnen ist, sollte möglichst die gesamte übrige Infrastruktur im Doppelbodensystem untergebracht werden, so auch Einrichtungen für die Raumkühlung.

Gerade Serverräume benötigen eine entsprechende Klimaanlage mit Überwachung der Raumtemperatur, damit im Raum keine Temperatur erreicht wird, die den reibungslosen Betrieb der Hardwarekomponenten gefährdet. Notwendig ist daher eine hinreichende Klimatisierung. Eine gewöhnliche Gebäudeklimatisierung ist für die Kühlung eines Servers nicht gut geeignet, da bei diesen Anlagen nur kleine Luftmengen mit niedriger Geschwindigkeit umgewälzt werden. Dies ist für die gezielte Kühlung von Servern nicht ausreichend und macht eine eigene Kühlinfrastruktur für Serverräume notwendig. Die Kühlung erfolgt oft mittels Klimaschränken, die neben den notwendig. Die Kühlung erfolgt oft mittels Klimaschränken, die neben den Servern angeordnet sind. Klimaschränke reduzieren jedoch das Platzangebot in den Serverräumen, was grundsätzlich auch im Hinblick auf einen möglichen Ausbau der Servereinrichtungen unerwünscht ist.

Die DE 20 2009 019 141 U1 offenbart eine Bodenstruktur für ein Rechenzentrum mit schräg bzw. V-förmig angeordneten wassergekühlten Kühlschlangen in einer Unterbodenkammer, wobei Axiallüfter, beispielsweise zwischen dem Rechnerraum und den Kühlschlangen angeordnet, gekühlte Luft durch ein im Raumboden integriertes Gitter in den Rechnerraum einblasen.

Die US 2008/016090 A1 beschreibt ebenfalls ein System zur Montage in einem Doppelboden eines Rechnerraumes mit V-förmigen Kühlelementen, wobei die Kühlelemente im Scheitel der V-Form im Wesentlichen verbunden sind. Ein Gebläse unterhalb der Kühlelemente saugt warme Luft an, welche an den Kühlelementen abkühlt. Zusätzlich sind Vorrichtungen zum Auffangen und Ableiten kondensierter Luftfeuchtigkeit vorgesehen.

Die DE 20 2016 105392 U1 offenbart eine Vorrichtung zur Kondensation eines Kühlmittels mittels Luftkühlung, wobei die Kondensatoren V-förmig, mit ihrer Längsachse geneigt, angeordnet sind. Ausgangsseitig bezüglich der Luftströmung ist ein Enthitzer angeordnet, der das überhitzte Kühlmittel vor dem kondensieren der Wärmeenergie abkühlen soll. Ebenfalls eine Vorrichtung zur Außenmontage zum Kühlen und/oder Kondensieren eines Kältemittels einer Klimaanlage ist aus der EP 226578A2 bekannt, wobei diese in einem Gerüst angeordnet ist. Über Steckverbindungen können mehrere Vorrichtungen modulartig zusammengefügt werden.

Die EP 1227286 A1 betrifft eine Vorrichtung zur Gebäudeklimatisierung, wobei die angesaugte Luft zunächst mittels eines ersten Wärmetauschers abgekühlt und befeuchtet wird und anschließend in einem zweiten Schritt wieder aufgewärmt wird. Dabei sind beide Wärmetauscher räumlich nahe beieinander und V-förmig angeordnet.

Des Weiteren offenbart die EP 1844637 B1 eine Anordnung zur Kühlung von Elektronik, beispielsweise in Serverschränken, wobei in selbigem Schrank eine Ventilatoreneinheit im Bereich einer Rückseite des Schranks mit Verlustwärme beaufschlagte Abluft aus dem Schrank absaugt und dabei vor Abgabe an die Umgebungsluft des Schranks zur Entwärmung durch einen Luft-Flüssigkeit-Wärmetauscher leitet.

Des Weiteren offenbart die DE 20 2010 002 639 U1 ein Kühlsystem zur Entwärmung von Elektronik in einem transportierbaren Behälter. Dieser Behälter weist einen Kältekreislauf und eine Luftkühlung auf, ist jedoch speziell für die Anwendung im militärischen Bereich konzipiert.

Bekannt sind aus dem Stand der Technik ferner in der DE 10 2012 106994 A1 zum Zweck der Klimatisierung von Serverräumen in Doppelbodensystemen von einer Kühlflüssigkeit durchströmte Wärmeübertrager. Eine Belüftungseinheit saugt Luft aus dem Serverraum durch den Raumboden an, welche anschließend durch das Klimagerät an den Wärmeübertragerflächen vorbeiströmt. Dabei wird die Raumluft abgekühlt und tritt durch den Raumboden wieder in den Serverraum. Nachteilig beim Stand der Technik ist ein fehlender Kondensatablauf von auskondensierter Raumfeuchte an den Wärmeübertragerflächen. Um die Kondensatbildung zu verhindern, dürfen die Wärmeübertragerflächen nicht zu sehr abgekühlt werden, was die potentielle Kühlleistung insgesamt verringert.

Die Aufgabe der vorliegenden Erfindung ist es, den bisherigen Stand der Technik zu verbessern. Insbesondere soll die Kühlleistung einer Kühleinheit in einem Doppelboden erhöht werden, ohne die nutzbare Bodenfläche eines zu kühlenden Raumes zu verkleinern.

Zur Lösung der Aufgabe wird das im Anspruch 1 angegebene Klimagerät für ein Doppelbodensystem und die im Anspruch 12 angegebene Bodenplatte für einen Doppelboden mit einem Klimagerät vorgeschlagen. Optionale, vorteilhafte Ausgestaltungen der Erfindung ergeben sich aus den abhängigen Ansprüchen.

Die Erfindung ist ein Klimagerät für ein Doppelbodensystem. Es ist geeignet zur Temperierung von geschlossenen Räumen, besonders ausgelegt jedoch zur Kühlung von Serverräumen oder Laboren. Das Klimagerät wird dabei von Luft aus dem Serverraum durchströmt. Die Durchströmung des Klimageräts kann dabei sowohl im Rahmen von freier, als auch im Rahmen von erzwungener Konfektion erfolgen. In dem Klimagerät befindet sich eine Wärmeübertragereinrichtung zur Abkühlung des durchströmenden Luftstroms. Die Wärmeübertragerfläche der Wärmeübertragereinrichtung wird dabei selbst von einem Kühlkreislauf kühl gehalten. Der Kühlkreislauf weist dabei ein Kältemittel als Wärmeübertragerfluid auf. Im einfachsten Fall kann dieses Fluid gekühltes Wasser sein. Die Kühlung des Wassers kann dabei beispielsweise extern des Klimageräts über eine Kältemaschine bereitgestellt werden, es ist für den Zulauf aber auch der gewöhnliche Hauswasseranschluss möglich. Die Wärmeübertragereinrichtung besteht vorzugsweise aus Kupferrohren und Aluminiumlamellen, allerdings sind auch andere Materialien denkbar. Dabei sind Rohre und Lamellen so ausgebildet und angeordnet, dass sie für die äußere Form des Wärmetauschers eine plattenförmige Grundform bzw. eine plattenförmige Gesamtstruktur ausbilden. Die Lamellen dienen dabei als Rippen für einen verbesserten Wärmeübergang mit der Luft. Auch für die Führung der Rohrleitung oder der Rohrleitungen im plattenförmigen Wärmetauscher sind verschiedene Ausführungsvarianten denkbar. Meist ist eine einzige Rohrleitung (einstückig oder mehrstückig) schlangenförmig bzw. mäanderförmig, in einer Ebene liegend, gebogen oder zusammengesetzt, innerhalb der plattenförmigen Grundform bzw. Gesamtstruktur geführt. Rohrleitungen und Lamellen bilden damit quasi ein Panel bzw. ein Paneel aus. Gegenüber dem Stand der Technik zeichnet sich das Klimagerät dadurch aus, dass dieser Wärmetauscher im Klimagerät mit einem Neigungswinkel größer als 0°gegenüber der horizontalen Ebene angeordnet ist. Dadurch kann das Kondensat, das sich an der Wärmeübertragerfläche beim Abkühlen der Luft, bedingt durch die allgemeine Luftfeuchtigkeit bildet, von der Wärmeübertragerfläche ablaufen und beispielsweise in einer Kondensatwanne aufgefangen werden. Dies erlaubt eine niedrigere Eintrittstemperatur des Kühlmittels in das Klimagerät, da durch die Ausrichtung des plattenförmigen Wärmetauschers mit Neigungswinkel die Kondensatbildung an der Oberfläche des Wärmeübertragers nicht mehr vermieden werden muss. Daher kann der plattenförmige Wärmetauscher theoretisch auch senkrecht angeordnet sein. Dimensionierung des Wärmetauschers und Neigungswinkel sind auch auf das Platzangebot im Doppelboden abzustimmen.

Bedingt durch die Neigung des Wärmetauschers gegenüber der horizontalen Ebene benötigt dieser in seiner horizontalen Abmessung auch nicht mehr so viel Platz. Dadurch wird der Platz frei für einen zweiten Wärmetauscher, der mit dem ersten Wärmetauscher vorzugsweise identisch ausgebildet ist. Dadurch kann eine größere Kühlleistung der Luft realisiert werden, ohne dass der notwendige Platzbedarf im Doppelboden zu stark ansteigt. Selbstverständlich können für große Kühlleistungen auch mehr als zwei Wärmetauscher verwendet werden. Erfindungsgemäß sind vorzugsweise alle Wärmetauscher identisch ausgebildet und mit dem gleichen Neigungswinkel entlang einer vertikalen Ebene, ausgerichtet. Erfindungsgemäß ist beispielsweise gegebenenfalls zusätzlich etwa jeder zweite Wärmetauscher identisch ausgebildet mit dem gleichen Neigungswinkel, aber zusätzlich entlang einer vertikalen Ebene gespiegelt, ausgerichtet.

In einer besonders vorteilhaften Ausführungsform der Erfindung werden zwei plattenartige Wärmetauscher relativ zueinander mit einer V-Form angeordnet, wobei die Wärmetauscher in einer Frontansicht wenigstens in Teilbereichen die Schenkel des V ausbilden. Dabei fällt die Symmetrieachse dieser V-Form mit einer vertikalen Ebene zusammen. Vorzugsweise ist dabei der Abstand der beiden Wärmetauscher zueinander auf der dem Boden des zu kühlenden Raumes zugewandten Seite größer, als auf der dem Boden abgewandten Seite. In anderen Worten zeigt damit der Scheitel bzw. die Spitze des V bevorzugt senkrecht nach unten, während die offene Seite des V senkrecht nach oben zeigt. Dadurch kann einerseits das Kondensat gut nach unten ablaufen, andererseits ist der notwendige Energieaufwand zum Ausgleich des Druckverlusts beim Ansaugen und Umwälzen der zu kühlenden Luft optimal. Damit das Kondensat nach unten ablaufen kann, berühren sich die Wärmetauscherplatten an der Spitze der V-Form nicht durchgehend. Sofern mehr als zwei Wärmetauscher eingesetzt werden, bilden in einer bevorzugten Ausführungsform jeweils zwei angrenzende Wärmetauscher miteinander eine entsprechende V-Form aus.

In einer vorteilhaften Ausführungsform sind daher die Schenkel der V-Form an ihrem Scheitel mit einem Abstand zueinander angeordnet. Damit bildet sich am gedachten Kreuzungspunkt der Schenkel des V, dem Scheitel, kein Berührungspunkt zwischen den Wärmetauscherplatten aus. Dieser Abstand kann über die gesamte Länge der Wärmetauscherplatten konstant, aber auch veränderlich sein.

Im Rahmen einer besonders vorteilhaften Ausführungsform der Erfindung kann der Verwender des Klimageräts jeden Wärmetauscher an einen eigenen Kühlkreislauf anschließen. Die notwendigen Anschlüsse hierfür (Zufluss- und Abflussleitungen) sind stets vorgesehen. Führen beispielsweise Leckagen zum Ausfall eines Kühlkreislaufs, können die anderen Kühlkreisläufe weiterbetrieben werden. Diese redundante Ausführung der Kühlung macht das Klimagerät besonders betriebssicher. Durch eine entsprechende Ausführung der Regelung können die verbleibenden funktionierenden Kühlkreisläufe so geregelt werden, dass es auch zu keinem Leistungsabfall bei der Kühlleistung kommt. Selbstverständlich kann der Verwender alle Wärmetauscher auch mit einem einzigen Kühlkreislauf verbinden.

Bedingt durch den erfindungsgemäßen Kondensatablauf und die dadurch resultierende tolerierbare Kondensatbildung, können beim Kältemittelzufluss niedrigere Temperaturen realisiert werden. Dadurch kann anstatt mit kühlem Wasser, auch mit einem Kältemittel gearbeitet werden, welches noch niedrigere Temperaturen erlaubt. Allgemein hat sich in der Kältetechnik ein zweiphasiger Kreislauf bewährt, bei dem ein entspanntes Kühlmittel im Wärmetauscher verdampft und dabei der Wärmeübertragerfläche Wärme entzieht. Die Nutzung dieser Phasenwechselenergie ermöglicht eine besonders effiziente und raumsparende Kühlung. Das verdampfte Kältemittel kann in einer separaten externen Vorrichtung wieder komprimiert, verflüssigt und entspannt werden.

Ebenfalls eine hohe Kühlleistung ist beispielsweise mit dem Kältemittel Glykol möglich. Mit Glykol als Wärmeträgerfluid bzw. Wärmeübertragerfluid lassen sich Temperaturen von bis zu -50 °C realisieren, wodurch die Kühlleistung des Klimageräts bei gleichbleibendem Platzbedarf enorm gesteigert werden kann.

In einer erfindungsgemäßen Ausführungsform wird ein Luftstrom durch das Klimagerät mit erzwungener Konvektion bereitgestellt. Die Vorrichtung zur Erzeugung der notwendigen Luftströmung an den Wärmeübertragerflächen vorbei wird dabei durch Strömungseinrichtungen umgesetzt, die in das Klimagerät fest integriert sind. Vorzugsweise ist die Strömungseinrichtung mit wenigstens einem Ventilator ausgeführt, der Luft aus dem Serverraum in das Klimagerät hinein ansaugt. Damit ist die Strömungseinrichtung als einfache Belüftungseinrichtung bzw. Belüftungseinheit ausgeführt. Die Wirkrichtung des Ventilators zeigt dabei senkrecht nach unten. Jedoch können auch Ventilatoren eingebaut werden, deren Wirkrichtung senkrecht nach oben zeigt.

In einer besonders vorteilhaften Ausführungsform sind mehrere Ventilatoren auf einer Montageplatte angeordnet, die sich zwischen dem Raumboden und der Wärmeübertragereinrichtung befindet. Durch diese Anordnung wird Luft von oben aus dem Serverraum durch ein Lüftungsgitter nach unten angesaugt und nach dem Durchtritt durch die Ventilatoren an den Wärmeübertragerflächen vorbeigeleitet.

In dem Doppelboden des Serverraumes befindet sich somit an dem Montageort des Klimageräts im Boden ein Lüftungsgitter, durch welches das Klimagerät die Luft ansaugt. Mithilfe dieses Lüftungsgitters kann die Kühlleistung des Klimageräts dadurch eingestellt werden, dass die Menge der in den Boden angesaugten Luft reguliert wird. Die Kühlleistung des Wärmetauschers selbst kann dabei unverändert bleiben. Durch die Veränderung der Querschnittsfläche der Öffnungen im Lüftungsgitter wird ebenfalls die Menge der pro Zeiteinheit durch die Bodenplatte transportierten Luft, also der Luftstrom, verändert. Selbstverständlich ist auch eine Regulierung des Luftstroms durch Regulierung der Ventilatorengeschwindigkeit möglich. In einer weiteren bevorzugten Ausführungsform sind die Lüftungsspalten in wenigstens zwei Abschnitte unterteilt sein, deren Querschnittsflächen unabhängig voneinander veränderbar sind. Dies ermöglicht eine richtungsabhängige Kühlung des Raums mit einer einzigen Bodenplatte.

Die Kühlleistung kann dabei vorzugsweise entweder durch die Einstellung des Luftstroms und/oder die Temperatur des Kältemittels und/oder den Durchflussmassenstrom des Kältemittels reguliert werden. Die notwendigen Messdaten für eine selbstständige Regulierung der Temperatur können beispielsweise durch Temperatursensoren oder Messgeräte bereitgestellt werden, die den Stromverbrauch der elektrischen Einrichtungen im Serverraum messen. Bei erhöhter Raumtemperatur und/oder erhöhtem Stromverbrauch der elektrischen Einrichtungen kann somit durch Erhöhung des Luftstroms, Erhöhung des Durchflussmassenstroms an Kältemittel und/oder die Absenkung der Kältemitteltemperatur die Kühlleistung des Klimageräts erhöht werden. Bei einem zweiphasigen Kältemittelkreislauf bietet sich auch die Variation der Druckniveaus an. Die notwendigen Funktionen zur Steuerung, Regelung und/oder Überwachung der Kühlleistung sind dabei fest im oder am Gehäuse des Klimageräts integriert, sodass dieses als autarke Einheit verwendet werden kann. Es ist nicht notwendig, die Hardware der elektronischen Einheit hierfür in einem separaten Schaltschrank anzuordnen.

Neben den Kühlkreisläufen können auch die Belüftungseinheiten redundant ausgeführt werden. Fällt beispielsweise von vier Ventilatoren einer bedingt durch eine technische Störung aus, kann die Steuerung die Leistung der verbleibenden drei Ventilatoren so erhöhen, dass der Luftstrom durch das Klimagerät konstant gehalten werden kann. Diese redundante Ausführung der Belüftungseinheiten führt zu einer verbesserten Ausfallsicherheit des Klimageräts für die Serverraumkühlung gegenüber technischen Störungen.

Eigenständiger Erfindungsschutz wird für eine Bodenplatte für einen Doppelboden mit einem Klimagerät, vorzugsweise geeignet zur Temperierung von geschlossenen Räumen, beansprucht. Dabei weist das Klimagerät wenigstens ein Lüftungsgitter auf, wobei das Lüftungsgitter als Einheit eines Raumbodens, insbesondere eines Serverraumbodens, ausbildbar und/oder ausgebildet ist. Ferner umfasst das Klimagerät unter anderem wenigstens eine von einem Wärmeübertragerfluid durchströmte oder durchströmbare Wärmeübertragereinrichtung zum Erwärmen oder Abkühlen von durch das Klimagerät durchströmender Luft, wobei die Wärmeübertragereinrichtung wenigstens einen Wärmetauscher mit einer plattenförmigen Grundform aufweist und der Wärmetauscher mit wenigstens einer Rohrleitung und vorzugsweise mit Lamellen gebildet ist. Des Weiteren ist wenigstens eine Strömungseinrichtung, vorzugsweise wenigstens ein Ventilator, zur Bereitstellung von in das Klimagerät einströmender bzw. von dem Klimagerät angesaugter Luft vorgesehen. Dabei ist die Strömungseinrichtung zwischen einem Lüftungsgitter und der Wärmeübertragereinrichtung angeordnet. Außerdem weist der Wärmetauscher gegenüber der horizontalen Ebene einen Neigungswinkel größer als 0° zum Abfluss von Kondensat an der luftzugewandten Seite der Wärmeübertragerfläche auf. Das Lüftungsgitter, welches bündig bzw. fluchtend mit dem Raumboden angeordnet ist, kann damit belastet werden, ohne dass zusätzliche Abstützelemente vorgesehen sein müssen. Vielmehr kann das Klimagerät selbst als Stützelement für den Raumboden, d.h. beispielsweise den Serverraumboden dienen. Somit kann das Lüftungsgitter des Klimageräts betreten oder auf eine andere Art und Weise belastet werden.

Weitere Einzelheiten, Merkmale, Merkmalskombinationen, Wirkungen und Vorteile der Erfindung ergeben sich aus der nachfolgenden Beschreibung vorteilhafter Ausführungsformen der Erfindung und den korrespondierenden Zeichnungen. Die Zeichnungen zeigen in
Fig. 1 eine isometrische Darstellung einer Anordnung aus Server, Serverraum und Doppelboden mit erfindungsgemäßem Klimagerät, in
Fig. 2 eine schematische Frontansicht eines erfindungsgemäßen Klimageräts mit ausgeblendeter stirnseitige Abdeckung, in
Fig. 3 eine Explosionsdarstellung eines erfindungsgemäßen Klimageräts mit montierter stirnseitiger Abdeckung.

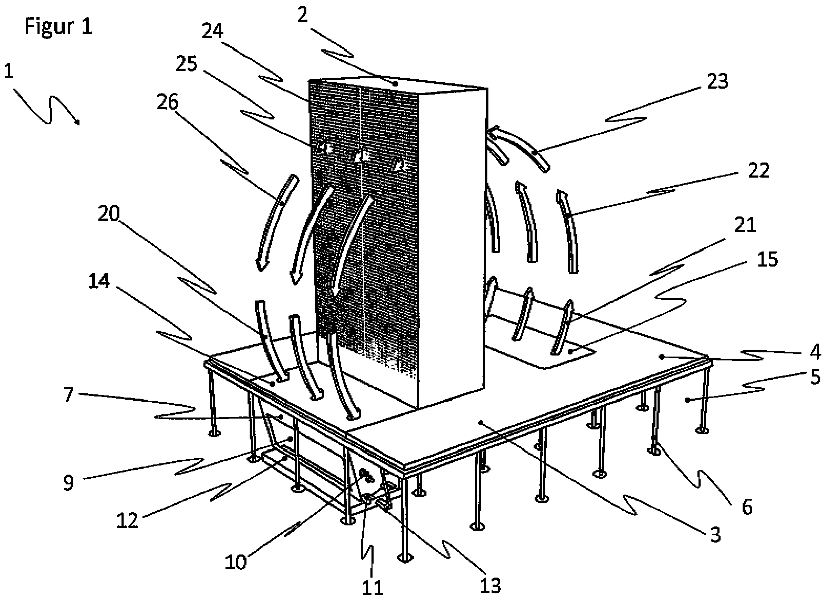

Figur 1 zeigt eine Anordnung 1 eines Servers 2 und einer Doppelbodenkühlung. Der Server 2 steht auf dem Boden 3 eines Serverraumes 4. Dieser Boden 3 trennt den Serverraum 4 von einem Zwischenraum 5 ab, dem sogenannten Doppelboden. Doppelböden 5 sind besonders attraktiv, da in diesen Infrastruktur für den Raum 4 untergebracht werden kann, ohne dass dabei die begehbare Bodenfläche 3 reduziert werden muss. In Figur 1 ist eine Anordnung mit Stützen 6 für den Raumboden 3 dargestellt. In dem Doppelboden 5 befindet sich das Klimagerät 7 zur Kühlung des Serverraumes 4. Dieses Klimagerät 7 weist einen gekühlten Wärmeübertrager 9 auf, an dessen Wärmeübertragefläche sich die Raumluft, die sich durch den Serverbetrieb aufgeheizt hat, wieder abkühlen kann. Zu diesem Zweck sind Anschlussleitungen für den Zufluss 10 und den Abfluss von Kältemittel vorgesehen, die über Ventile entlüftet und über Ablasshähne 34 entleert werden können. Wie bereits beschrieben, bildet sich bei der Kühlung der Raumluft Kondensat an der Oberfläche des Wärmeübertragers 9. Dieses Kondensat läuft nach unten ab und wird in einer Wanne 12 aufgefangen. Die Wanne kann mittels einer Pumpeinrichtung 13 entleert werden. Für die Kondensatabfuhr sind alle gängigen Vorrichtungen aus dem Stand der Technik möglich. Die Luftzufuhr 20 in das Klimagerät 7 erfolgt über ein Lüftungsgitter 14, das gleichzeitig zur Verteilung der Luft im Klimagerät 7 eingesetzt ist. Die Luftabfuhr 21 der gekühlten Luft aus dem Doppelboden 5 zurück in den Serverraum 4 erfolgt über ein weiteres Lüftungsgitter 15. Das Lüftungsgitter 14 zur Ansaugung 20 der Luft ist in dieser Abbildung direkt mit dem Klimagerät 7 verbunden. Die frischgekühlte Raumluft 21 zirkuliert im Serverraum 22 und gelangt schließlich durch eine Gitterstruktur 24 des Servergehäuses in den Server 2, wobei der Server 2 dabei eigenständig seine benötigte Frischluft 23 ansaugt. Dort, bedingt durch die elektrischen Arbeitsprozesse, erwärmt sich die Luft und tritt aufgeheizt 25 aus dem Servergehäuse in den Serverraum 4. Dort zirkuliert 26 die aufgeheizte Luft so lange, bis sie wieder von dem Klimagerät 7 durch das Lüftungsgitter 14 hindurch angesaugt 20 wird.

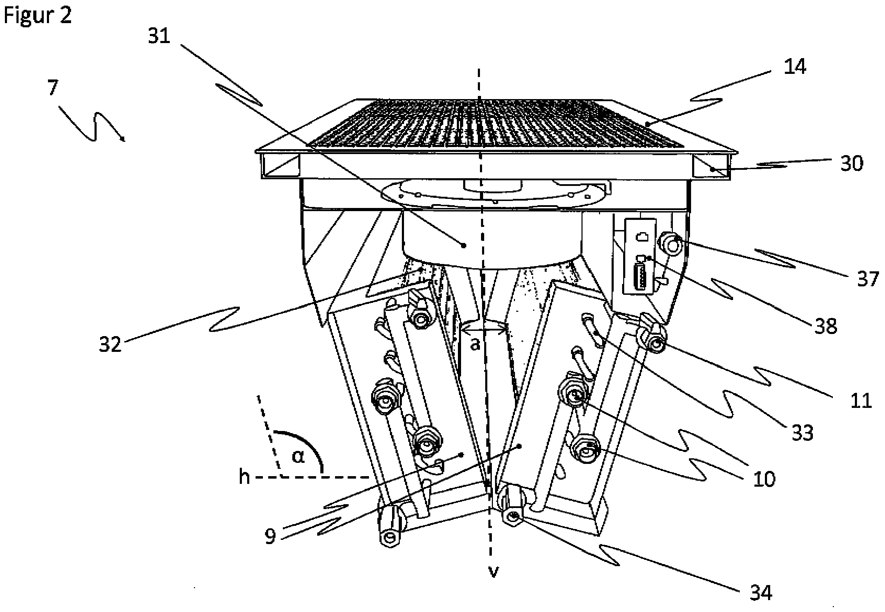

Figur 2 zeigt ein erfindungsgemäßes Klimagerät 7 in einer Frontansicht von der Stirnseite aus betrachtet, wobei eine stirnseitige Abdeckung zur besseren Darstellung entfernt ist. Eingezeichnet sind zur besseren Verständlichkeit die vertikale Ausrichtung v und die horizontale Ausrichtung h. Die Luft wird von einer Belüftungseinheit 31 durch das Belüftungsgitter 14 hindurch in das Klimagerät 7 hinein angesaugt. Dabei weist das Belüftungsgitter 14, typisch für Doppelbodenabdeckungen Kabelschächte 30 zur Verlegung elektrischer Leitungen auf. Die Belüftungseinheit, hier ausgeführt als Ventilator 31, führt die angesaugte Luft an der Wärmeübertragereinrichtung 9 vorbei. Diese besteht aus zwei zueinander V-förmig angeordneten plattenförmig ausgebildeten Wärmeübertragereinheiten 9, die senkrecht nach unten zueinander konvergieren. In der gezeigten Ausführungsform sind die Schenkel der V-Form an ihrem Scheitel stets mit einem Abstand a versehen, sie berühren sich also nicht. In einer bevorzugten Ausführungsform bestehen die Wärmeübertragereinheiten 9 aus gebogenen Kupferrohren 33 und Aluminiumlamellen 32. Über Anschlussstutzen 10 sind die Kupferrohre 33 mit einem Kältemittel bei der Inbetriebnahme befüllbar und im stationären Betrieb durchströmbar. Entlüftungsventile 11 ermöglichen die Entlüftung der Kupferrohre 33, so wie es bei Heizungsanlagen notwendig ist. Beim Ausbau des Klimageräts 7 kann die Kühlflüssigkeit aus den Kupferrohren 33 über Ablasshähne bzw. Entleerhähne 34 abgelassen werden. Da die beiden Wärmeübertrageeinheiten 9 je über einen eigenen Kühlkreislauf betreibbar sein sollen, sind Anschlussstutzen 10, Entlüftungsventile 11 und Ablasshähne bzw. Entleerhähne 34 für jede Wärmeübertragereinheit 9 separat ausgeführt. Erfindungsgemäß sind die beiden plattenförmig ausgebildeten Wärmeübertragereinheiten 9 unter Ausbildung einer in der Frontansicht erkennbaren V-Form ausgebildet, wobei eine vertikale Ebene v gleichzeitig im Wesentlichen der Symmetrieebene v der Anordnung der Wärmeübertragereinheiten 9 entspricht. Wenigstens eine Seitenkante bzw. im Wesentlichen eine Seitenfläche der Wärmeübertragereinheit 9 schließen mit einer horizontalen Ebene h den Winkel α ein, der damit den Neigungswinkel der Wärmeübertragereinheit darstellt. Das Kondensat, welches sich an der Außenseite der Kupferrohre 33 und/oder der Aluminiumlamellen 32 bildet, kann, bedingt durch den Neigungswinkel, nach unten abfließen und in einer hier nicht dargestellten Wanne 12 aufgefangen werden. Zur Stromversorgung weist das Klimagerät 7 einen Stromanschluss 37 auf. Des Weiteren ist es Klimagerät 7 mit Funktionen zur Steuerung, Regelung und/oder Überwachung ausgestattet. Zum Empfang und zum Versenden von Daten (beispielsweise Messdaten oder Steuerungsbefehlen), weist das Klimagerät eine entsprechende Funktionseinheit mit Schnittstelle 38 zur Datenübertragung auf.

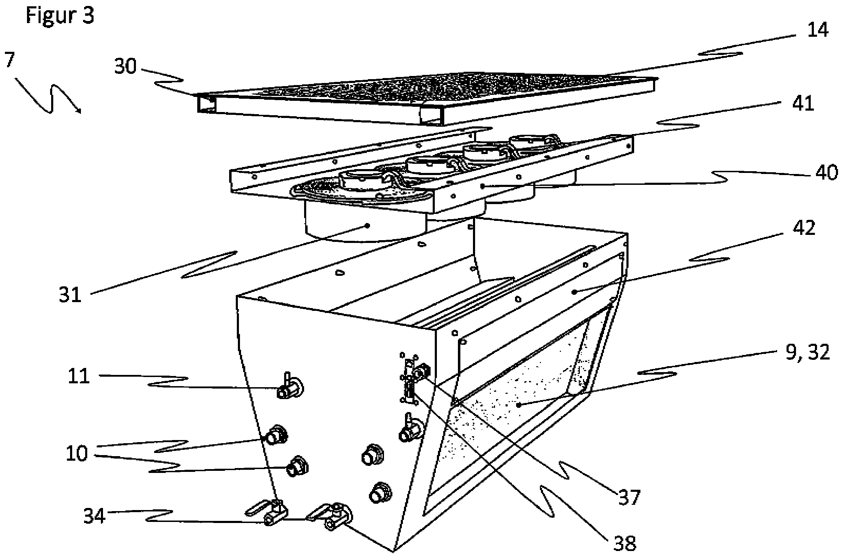

Figur 3 zeigt das Klimagerät 7 zur anschaulichen Darstellung der Strömungseinrichtungen bzw. Belüftungseinheiten 31 in einer Explosionszeichnung. Dabei sind gemäß der Darstellung vier Ventilatoren 31 auf einer Montageplatte 40 in Reihe angeordnet. Je nach Ausformung ist jedoch eine andere Anzahl an Ventilatoren 31 und auch eine andere Anordnung möglich. Die Montageplatte 40 ist dabei direkt unterhalb des Lüftungsgitters 14 zur optimalen Luftansaugung 20 angeordnet. Die Ventilatoren 31 sind in ihrer Drehzahl zur Einstellung des Luftmassenstroms regelbar. Gleichzeitig sind die Belüftungseinheiten 31 redundant ausgeführt. Sofern also eine Belüftungseinheit 31, beispielsweise bedingt durch einen technischen Defekt, ausfällt, kann die Drehzahl der verbleibenden Belüftungseinheiten 31 zur Konstanthaltung der gesamten Kühlleistung entsprechend angepasst werden. Die notwendigen elektrischen Anschlüsse 41 hierfür können beispielsweise durch die Kabelschächte 30 des Lüftungsgitters 14 verlegt werden. In Figur 3 ist das Gehäuse des Klimageräts 7 vollständig dargestellt. Für die Zugänglichkeit zu den Wärmeübertragereinheiten 9 weist das Gehäuse Wartungsklappen 42 auf. An einer Stirnseite befinden sich erfindungsgemäß die Anschlüsse für zwei separate Kühlkreisläufe 10, 11, 34 und die Schnittstellen für die Stromversorgung 37 und die Datenübertragung 38. Der Luftmassenstrom, der durch das Lüftungsgitter 14 angesaugt wird, tritt zwischen den Lamellen 32 der Wärmeübertragereinheit 9 aus dem Klimagerät 7 in den Doppelboden 5. Von dort aus gelangt er über einen weiteres Lüftungsgitter 15 wieder durch den Boden 3 in den zu kühlenden Serverraum 4, wo die Luft wieder zur Kühlung des Servers 2 zur Verfügung steht.

### Bezugszeichenliste

1 Anordnung aus Server und Klimagerät im Doppelboden
2 kühlbarer Server
3 Serverraumboden
4 Serverraum
5 Zwischenraum/Zwischenboden/Doppelboden
6 Abstützung Versuchsstand
7 Klimagerät
9 Wärmeübertragereinheit
10 Anschluss für Kreislauf
11 Entlüftungsventil
12 Kondensatwanne
13 Kondensatabfuhr/Kondensatpumpe
14 Luftabzugsgitter/Luftverteilereinrichtung
15 Lüftungsgitter
20 Luftansaugung / Warmluftabfuhr aus Serverraum
21 Kaltluftzufuhr Serverraum
22 Kaltluftzirkulation im Serverraum
23 Kaltluftzufuhr Server
24 Gitterstruktur des Servergehäuses
25 Warmluftabfuhr Server
26 Warmluftzirkulation im Serverraum
30 Kabelschächte
31 Strömungseinrichtungen/Belüftungseinheiten/Ventilatoren
32 Wärmeübertragerfläche/Lamellen/Kühlrippen
33 Wärmeübertragerrohr
34 Ablasshähne
37 Stromzufuhr/Schnittstelle für Stromzufuhr
38 Schnittstelle bzw. Funktionseinheit zur Steuerung/Regelung/Überwachung
40 Montageplatte für Belüftungseinheiten
41 Stromzufuhr/Elektrische Anschlüsse für Belüftungseinheiten
42 Wartungsklappe
α Neigungswinkel der Wärmetauscher gegenüber einer horizontalen Ebene
a Abstand der Schenkel der V-Form im Scheitel
h horizontale Ebene
v vertikale Ebene, Symmetrieebene der V-Form

## Patentansprüche

1. Klimagerät (7) für ein Doppelbodensystem, vorzugsweise geeignet zur Temperierung von geschlossenen Räumen, aufweisend wenigstens eine von einem Wärmeübertragerfluid durchströmte oder durchströmbare Wärmeübertragereinrichtung (9) zum Erwärmen oder Abkühlen von durch das Klimagerät (7) durchströmender Luft (20),
wobei die Wärmeübertragereinrichtung (9) wenigstens einen Wärmetauscher (32, 33) mit einer plattenförmigen Grundform aufweist, welcher Wärmetauscher (32, 33) mit wenigstens einer Rohrleitung (33) und vorzugsweise mit Lamellen (32) gebildet ist,
wobei die in das Klimagerät (7) einströmende bzw. von dem Klimagerät (7) angesaugte Luft (20) mit einer in das Klimagerät (7) integrierten Strömungseinrichtung, vorzugsweise wenigstens einem Ventilator (31), bereitgestellt ist und die Strömungseinrichtung zwischen einem Lüftungsgitter (14) und der Wärmeübertragereinrichtung (9) angeordnet ist, **dadurch gekennzeichnet, dass**
der Wärmetauscher (32, 33) gegenüber der horizontalen Ebene (h) einen Neigungswinkel (a) größer als 0° zum Abfluss von Kondensat an der luftzugewandten Seite der Wärmeübertragerfläche aufweist.

2. Klimagerät (7) nach Anspruch 1, **dadurch gekennzeichnet, dass** die Wärmeübertragereinrichtung (9) wenigstens einen weiteren Wärmetauscher (32, 33) mit einer plattenförmigen Grundform aufweist und jeder weitere Wärmetauscher (32, 33) gegenüber der horizontalen Ebene (h) ebenfalls einen Neigungswinkel (α) größer als 0° zum Abfluss von Kondensat an der luftzugewandten Seite der Wärmeübertragerfläche aufweist.

3. Klimagerät (7) nach Anspruch 2, **dadurch gekennzeichnet, dass** die wenigstens zwei Wärmetauscher (32, 33) V-artig oder mit einer V-Form relativ zueinander derart angeordnet sind, dass eine Symmetrieachse der V-Form mit einer vertikalen Ebene (v) zusammenfällt.

4. Klimagerät nach Anspruch 3, **gekennzeichnet durch** einen Abstand (a) der Schenkel der V-Form, welche Schenkel mit den plattenförmigen Wärmetauschern (32, 33) gebildet werden, im Scheitel der V-Form.

5. Klimagerät (7) nach einem der Ansprüche 2-4, **dadurch gekennzeichnet, dass** jeder einzelne der wenigstens zwei Wärmetauscher (32, 33) von einem eigenen Wärmeträgerfluidkreislauf (10) durchgeströmt oder durchströmbar ist.

6. Klimagerät (7) nach einem der vorangehenden Ansprüche, **dadurch gekennzeichnet, dass** in der Rohrleitung oder den Rohrleitungen (33) des Wärmetauschers oder der Wärmetauscher (32, 33) beim Abkühlen oder Erwärmen von Luft, die das Klimagerät durchströmt, ein Verdampfungs- oder Kondensationsvorgang stattfindet.

7. Klimagerät (7) nach einem der vorangehenden Ansprüche, **gekennzeichnet durch** die Verwendung von Glykol als Wärmeträgerfluid.

8. Klimagerät (7) nach einem der vorangehenden Ansprüche, **dadurch gekennzeichnet, dass** die Strömungseinrichtung (31) auf einer plattenartigen Montagevorrichtung (40) montiert und oberhalb der Wärmeübertragereinrichtung (9) und unterhalb eines Raumbodens (3) angeordnet oder anordenbar ist.

9. Klimagerät (7) nach einem der vorangehenden Ansprüche, **gekennzeichnet durch** ein Lüftungsgitter (14, 15) mit Lüftungsöffnungen, deren Querschnitt zur Regulierung des durchströmenden Luftstroms (20) veränderbar sind.

10. Klimagerät (7) nach einem der vorangehenden Ansprüche, **gekennzeichnet durch** eine elektronische Funktionseinheit (38) zur Steuerung, Regelung und Überwachung der im Klimagerät (7) ablaufenden Prozesse.

11. Klimagerät (7) nach Anspruch 10, **dadurch gekennzeichnet, dass** wenigstens zwei Ventilatoren (31) der Strömungseinrichtung redundant ausgeführt sind.

12. Bodenplatte für einen Doppelboden (5) mit einem Klimagerät (7), insbesondere mit einem Klimagerät (7) der Ansprüche 1-11, vorzugsweise geeignet zur Temperierung von geschlossenen Räumen, wobei das Klimagerät (7) aufweist
wenigstens ein Lüftungsgitter (14), wobei das Lüftungsgitter (14) als Einheit eines Raumbodens, insbesondere eines Serverraumbodens (3), ausbildbar und/oder ausgebildet ist,
wenigstens eine von einem Wärmeübertragerfluid durchströmte oder durchströmbare Wärmeübertragereinrichtung (9) zum Erwärmen oder Abkühlen von durch das Klimagerät (7) durchströmender Luft (20), wobei die Wärmeübertragereinrichtung (9) wenigstens einen Wärmetauscher (32, 33) mit einer plattenförmigen Grundform aufweist, wobei ferner der Wärmetauscher (32, 33) mit wenigstens einer Rohrleitung (33) und vorzugsweise mit Lamellen (32) gebildet ist,
wenigstens eine Strömungseinrichtung, vorzugsweise wenigstens einen Ventilator (31), zur Bereitstellung von in das Klimagerät (7) einströmender bzw. von dem Klimagerät (7) angesaugter Luft (20), wobei die Strömungseinrichtung zwischen einem Lüftungsgitter (14) und der Wärmeübertragereinrichtung (9) angeordnet ist,
**dadurch gekennzeichnet, dass**
der Wärmetauscher (32, 33) gegenüber der horizontalen Ebene (h) einen Neigungswinkel (a) größer als 0° zum Abfluss von Kondensat an der luftzugewandten Seite der Wärmeübertragerfläche aufweist.
